Europäisches Patentamt

European Patent Office

Office européen des brevets

(19)

(11) Veröffentlichungsnummer : **0 069 843 B2**

(12) **NEUE EUROPÄISCHE PATENTSCHRIFT**

(45) Veröffentlichungstag der neuen Patentschrift:
**03.04.91 Patentblatt 91/14**

(21) Anmeldenummer : **82104105.0**

(22) Anmeldetag : **12.05.82**

(51) Int. Cl.⁵ : **H04N 5/50, H03G 3/34,
H03G 11/08**

(54) **NF-Verstärker für ein Fernsehgerät.**

(30) Priorität : **10.07.81 DE 3127278**

(43) Veröffentlichungstag der Anmeldung :
**19.01.83 Patentblatt 83/03**

(45) Bekanntmachung des Hinweises auf die
Patenterteilung :
**13.11.85 Patentblatt 85/46**

(45) Bekanntmachung des Hinweises auf die
Entscheidung über den Einspruch :
**03.04.91 Patentblatt 91/14**

(84) Benannte Vertragsstaaten :
**AT CH FR GB IT LI**

(56) Entgegenhaltungen :
**DE-A- 2 328 673
DE-A- 2 542 502
DE-A- 2 854 196
DE-B- 2 832 269
FR-A- 2 183 569**

(56) Entgegenhaltungen :
**US-A- 3 867 709
US-A- 4 238 771
IEEE TRANSACTIONS ON CONSUMER ELEC-
TRONICS, Band CE-21, Nr.3, August 1975, New
York (US) J. CRAFT et al.: "A monolithic decoder for CD-4 disc recordings", Seiten 185-194
Funkschau, Jahr 1968, Heft 4, Seite 6
Blaupunkt- Kundendienstschrift, Nr.772 04
002.20 für das Fernsehgerät "Scout Royal 7
673 140, Seiten 1, 40 bis 48
Blaupunkt I Radio-Phono FernsehKatalog
1973/74, Teil A, Seite 28**

(73) Patentinhaber : **Deutsche Thomson-Brandt
GmbH
Hermann-Schwer-Strasse 3 Postfach 1307
W-7730 Villingen-Schwenningen (DE)**

(72) Erfinder : **Geiger, Erich, Ing. grad.
Panoramablick 19
W-7731 Unterkirnach (DE)**
Erfinder : **Jaag, Herbert
Am Schwalbenhaag 1
W-7730 Villingen-Schwenningen (DE)**

EP 0 069 843 B2

## Beschreibung

Der Ein- und Ausschaltknacks wird bei NF-Verstärkern als störend empfunden. Bei größerer Lautstärke kann dieses Störgeräusch den Lautsprecher beschädigen. Eine mögliche Lösung sind schnell ansprechende Schalter, beispielsweise Relais, die man dem Lautsprecher vorschaltet. Der Lautsprecher wurde erst dann eingeschaltet, wenn sich ein stabiler Zustand nach dem Einschalten eingestellt hat. Desgleichen wurde auch der Ausschaltknacks verhindert. Nachteilig ist dabei der relativ hohe Schaltungsaufwand und die relativ teueren Bauteile, z. B. ein Relais.

Stummsteuerschaltungen (Mute-Schaltungen) sind beispielsweise aus der US-PS 4 238 771 und der DE-OS 2 832 269 bekannt und betreffen Signalempfänger für Amplitudenmodulation, Fernsehgeräte oder Hörrundfunkempfänger. Im Falle der US-PS soll das störende Taktsignal in der Tonwiedergabe durch eine Stummschaltung verhindert oder unterdrückt werden, das bei solchen Geräten auftritt, wenn sie einen Synchron- Detektor verwenden. Es liegt die Aufgabe zugrunde, dieses Taktsignal sowie »Weißes Rauschen« zu unterdrücken, aber nicht das Rauschen zwischen Stationen bzw. das störende Knacken beim Ein- und Ausschalten. Die Lösung sieht eine sogenannte »kalte Lautstärkeregelung« vor, also gleichstrommäßig.

Die DE-OS 2 832 269 betrifft eine monolithisch integrierte Schaltung für die Horizontalablenkung von Fernsehgeräten, die nach dieser Erfindung eine Stummschaltung enthält, um verrauschte TV-Eingangssignale oder Signale, die keine TV-Signale sind, ganz zu unterdrücken. Es besteht mit dieser HF- Differenz-Verstärkerschaltung keine Möglichkeit im Tonkanal Ein- und Ausschaltknacken zu unterdrücken.

Aus der DE-OS 2 542 502, Zusatz zu DE-OS 2 413 839.4, ist die Anwendung eines speziellen 6 Pin-IC für ein Fernsehgerät mit Bild-im-Bild-Wiedergabe zu entnehmen, wobei für die Dauer von Zeilen der Tuner und der ZF-Verstärker zwischen zwei Empfangssignalen umgeschaltet wird. Das hierbei hörbare NF-Schaltknacken soll durch diese Erfindung unterdrückt werden. Das ist eine besondere Aufgabe. Es wird hier nicht eine Stummschaltung bzw. Abschaltung verrauschter TV-Signale oder Nicht-TV-Signale angestrebt. Auch können die beschriebenen Lösungswege keine Maßnahme gegen Ein- und Ausschaltknacken bieten.

Aus der US-PS 3 867 709 ist eine Stummsteuerung zur Knack- und Störgeräuschunterdrückung bekannt. Die beschriebene Lösung sollte die Aufgabe lösen, Störgeräusche zu unterdrücken, die speziell bei schnellem Vor- und Rücklauf von Bandgeräten auftreten, und dies mit einer elektronischen Schaltung im Tonverstärker erreichen, nachdem zuvor mechanische und elektromechanische Lösungen desselben Problems nicht zufriedenstellend arbeiteten. Die Schaltung gemäß dieser US-PS sieht vor, daß beim Schließen des Schalters SW der Ausgang (Pin 4) ohne, jede Verzögerung »hart« stummgeschaltet wird, so daß ein Knackgeräusch übertragen werden kann.

Die von R7, R8 und $C_4$ gebildete Zeitkonstante am Differenzverstärkereingang (Pin 5) ist dabei ohne Bedeutung.

Neuerdings wird von der Post eine Stummsteuerung der NF in Fernsehempfängern gefordert, wenn das empfangene Signal sehr schwach oder kein Fernsehsignal ist. Eine bekannte Lösung ist die Stummsteuerung mit Hilfe eines sogenannten Mute-Signals (Stummsteuersignal), das bei fehlenden Synchronimpulsen erzeugt wird und auf den Ton-ZF-Verstärker bzw. über die Lautstärkeeinstellung wirksam wird.

Der vorliegenden Erfindung lag somit die Aufgabe zugrunde, sowohl eine Störgeräuschunterdrükkung wie auch eine Stummsteuerung des NF-Verstärkers eines Signalempfängers, insbesondere Fernsehgerätes, mit geringstmöglichem Aufwand so zu realisieren, daß auch störende Knackgeräusche beim Ein- und beim Ausschalten unterdrückt werden und daß bei Stand-by-Betrieb die Stromentnahme des Gerätes sehr gering ist.

Diese Aufgabe wird für einen NF-Verstärker gemäß dem Oberbegriff des Anspruchs erfindungsgemäß nach dessen Kennzeichen gelöst.

Weitere Einzelheiten sind der Beschreibung eines Ausführungsbeispiels zu entnehmen.

Der NF-Verstärker für den elektroakustischen Wandler eines Fernsehgerätes ist mit einem Differenz-Verstärker-IC ausgeführt. Derartige integrierte Schaltungen besitzen einen invertierenden Eingang, der zum Anschluß einer Gegenkopplung gern verwendet wird. Wenn das Fernsehgerät mit einer Detektorschaltung ausgestattet ist, die eine Spannung bei Empfang eines Fernsehsenders abgibt, dann kann diese Spannung nach der Erfindung als Steuersignal für einen Halbleiterschalter dienen, der auf einfache Weise eine über einen unterteilten Vorwiderstand aus der Betriebsspannung für den NF-Verstärker abgeleitete Spannung schaltet. Wenn kein Detektorsignal vorhanden ist, liegt diese Spannung am invertierenden Eingang des Differenz-Verstärkers und steuert diesen stumm. Dadurch wird vorteilhafterweise im sogenannten Stand-By-Betrieb, der gegenwärtig gern angewendet wird, die Ruhestromaufnahme des NF-Verstärkers fast Null und so die Stromaufnahme des Gerätes bei dieser Betriebsart sehr gering, obwohl die Betriebsspannung, die direkt aus dem Netz stammt, während dieser Betriebsart ständig am Differenzverstärker anliegt. Außerdem wird die Forderung nach Unterdrückung der Störgeräusche und die Postforderung nach Stummsteuerung gemäß der gestellten Aufgabe auf ideale Weise erfüllt

2

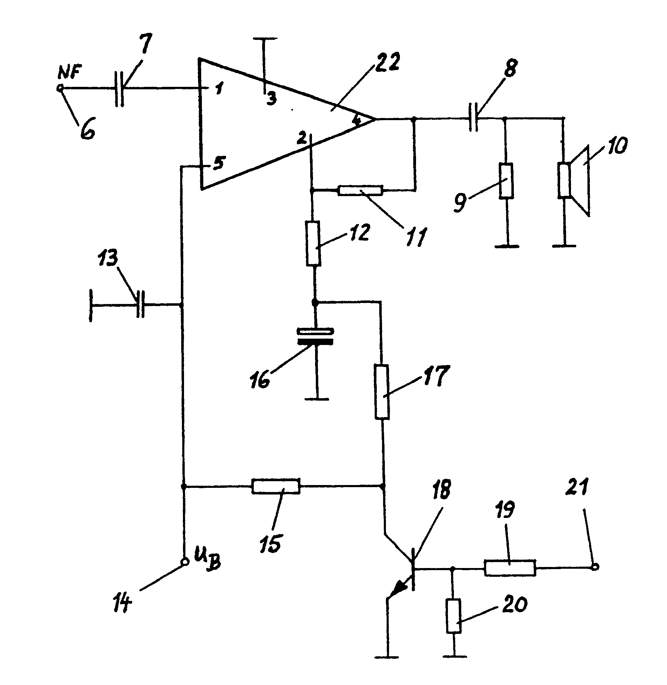

Die erfindungsgemäße Schaltung wird nachfolgend anhand der Zeichnung, die nur eine Figur aufweist, beschrieben.

Der NF-Verstärker ist auf bekannte Weise mit einem Differenz-Verstärker-IC 22 ausgeführt. Am Anschluß 6 wird die zu verstärkende Tonfrequenz über einen Koppelkondensator 7 dem Eingangs-Pin 1 zugeführt. Der Pin 3 liegt an Masse. Zwischen dem Ausgangs-Pin 4 und dem invertierenden Eingang (Pin 2) liegt ein Gegenkopplungswiderstand 11, an welchem ein RC-Glied bestehend aus dem Widerstand 12 und dem Kondensator 16 angeschlossen ist. Die verstärkte Tonfrequenz gelangt vom Ausgangs-Pin 4 über den Koppelkondensator 8 und den Siebwiderstand 9 an den elektroakustischen Wandler, den Lautsprecher 10. Am Pin 5 wird die Betriebsspanung $U_B$ vorn Anschluß 14 über den Siebkondensator 13 zugeführt. Zwischen dem Anschluß 14 und dem Verbindungspunkt des RC-Gliedes 12, 16 ist ein aus zwei Widerständen 15 und 17 bestehender Vorwiderstand angeschlossen. Ein Halbleiterschalter, hier der NPN-Transistor 18, liegt mit seinem Collektor an dem Verbindungspunkt des aufgeteilten Vorwiderstandes 15, 17. Sein Emitter ist mit Masse verbunden. Seine Basis liegt über die Widerstandskombination 19 und 20 am Anschluß 21, dem das Stummsteuersignal vom nicht dargestellten Detektor des Fernsehgerätes zugeführt wird. Die Funktionsweise ist nun folgende : Im Stand-By-Betrieb liegt die volle Betriebsspannung $U_B$ am Anschluß 14 und damit auch am Pin 5 des Differenz-Verstärkers 22. Der Transistor 18 ist gesperrt, weil kein Signal vom Detektor am Anschluß 21 anliegt. Damit liegt am Pin 2, dem invertierenden Eingang des Differenzverstärkers 22, die Sperrspannung über den Widerstand 12. Der Differenzverstärker 22 bleibt stumm gesteuert, seine Ruhestromaufnahme ist praktisch Null Das Fernsehgerät verbraucht für den NF-Vestärker praktisch keinen Strom.

Beim Einschalten des Fernsehgerätes gelangt ein Signal eines Fernsehsenders an den Detektor, der dem Anschluß 21 ein entsprechendes Signal zuleitet (damit fehlt quasi das sogenannte Stummsteuer-(Muting) Signal, das den Transistor 18 durchschaltet, die Collektor-Emitter-Strecke wird leitend. Dadurch entlädt sich der Kondensator 16 und die sperrende Spannung am invertierenden Eingang (Pin 2) reduziert sich auf die Arbeitsspannung, als Folge davon verstärkt der Differenzverstärker 22 erst mit einer gewünschten Zeitverzögerung, wodurch der Einschaltknacks wirkungsvoll unterdrückt wird.

Wenn auf einen anderen Sender abgestimmt wird, entfällt zunächst das Signal vom Detektor solange Rauschen oder ein Nicht-Fernsehsender empfangen wird. Dabei sperrt der Transistor 18 und die Sperrspannung liegt wieder am invertierenden Eingang bis erneut auf einen Fernsehsender abgestimmt ist, wodurch der Detektor wieder ein Signal an den Anschluß 21 liefert. Dann wird der Transistor 18 wieder durchgeschaltet, die Sperrspannung am invertierenden Eingang entfällt und der NF-Verstärker arbeitet wieder und speist den Lautsprecher 10.

Die Abschaltknacksunterdrückung geschieht bei geeigneter Wahl der Zeitkonstanten des RC-Gliedes und der Werte der angeschlossenen mitbestimmenden Widerstände, indem man dafür sorgt, daß die Sperrspannung am invertierenden Eingang (Pin 2) nach dem Abschalten des Gerätes bereits wirksam wird bevor der Knacks hörbar werden kann.

**Liste der in einem praktisch ausgeführten und erprobten Ausführungsbeispiel verwendeten Bauteile**

| Position Nr. | | | |
|---|---|---|---|
| 22 | Differenz-Verstärker-IC | TDA-2006 |
| 18 | NPN Transistor | BC 548 B |
| 16 | Kondensator des RC-Gliedes | 10 uF |
| 8 | Koppelkondensator | 220 uF |
| 11 | Gegenkopplungs-Widerstand | 100 k Ohm |
| 12 | Widerstand des RC-Gliedes | 3,3 k Ohm |
| 9 | Sieb-Widerstand | 470 k Ohm |
| 15 | Widerstand | 100 k Ohm |
| 17 | Widerstand | 82 k Ohm |
| 19 | Widerstand | 120 k Ohm |
| 20 | Widerstand | 10 k Ohm |

**Ansprüche**

1. NF-Verstärker für den elektroakustischen Wandler (10) eines Signalempfängers, insbesondere Fernsehempfängers, mit einem Differenzverstärker-IC (22) über die das am Eingang (Anschluß 1) anliegende NF-Signal verstärkt bzw. unterdrückt und am Ausgang (Anschluß 4) abgegeben bzw. gesperrt wird und mit einer frequenzabhängigen Gegenkopplung mit einem RC-Glied aus einem zwischen dem Ausgang (Anschluß 4) und

EP 0 069 843 B2

dem invertierenden Eingang (Anschluß 2) liegenden Widerstand (11) sowie einer zwischen dem invertierenden Eingang (Anschluß 2) und Masse liegenden Serienschaltung aus einem Widerstand (12) und einem Kondensator (16), wobei der Empfänger mit einer Detektorschaltung ausgestattet ist, die eine Spannung abgibt solange ein Signal empfangen wird, wobei dem Kondensator (16) des Gegenkopplungskreises (11, 12, 16) eine aus der Betriebsspannung (UB, Anschluß 14) über Vorwiderstände (15, 17) abgeleitete Spannung zugeführt wird und diese abgeleitete Spannung mittels eines Halbleiterschalters (18) von einer Spannung steuerbar ist, die der von dem Detektor (am Anschluß 21) abgegebenen Spannung entspricht und die dem Steueranschluß des Halbleiterschalters (18) zugeführt wird, **dadurch gekennzeichnet,** daß ein Anschluß des Widerstandes (12) der Serienschaltung mit dem invertierenden Eingang (Anschluß 2), ein Anschluß des Kondensators (16) der Serienschaltung mit Masse und der gemeinsame Anschluß des Widerstandes (12) und Kondensators (16) mit dem Vorwiderstand (17) verbunden ist, daß der Halbleiterschalter (18) zwischen dem gemeinsamen Anschluß der Vorwiderstände (15, 17) und Masse liegt und daß die dem Halbleiterschalter (18) zugeführte Spannung an eine Serienschaltung aus zwischen dem Anschluß (21) und Masse liegenden Widerständen (19, 20) angelegt ist, dessen gemeinsamer Anschluß mit dem Steueranschluß des Halbleiterschalters (18) verbunden ist, so daß die den IC (22) sperrende Spannung zu Störgeräuschunterdrückung mit solcher Verzögerung an- und abgeschaltet wird, daß beim Einschalten aus dem Stand-by-Betrieb die am Kondensator (16) anliegende Spannung mit einer Zeitkonstanten entladen wird, die das Einschaltknackgeräusch unterdrückt, und daß beim Umschalten in den Stand-by-Betrieb die Zeitkonstante des RC-Gliedes (11, 12, 16) über die Werte der angeschlossenen mitbestimmenden Widerstände so gewählt wird, daß am invertierenden Eingang (Pin 2) des IC (22) eine Sperrspannung wirksam wird, bevor ein Abschaltknackgeräusch hörbar werden kann.

## Claims

1. Low frequency amplifier for the electro-acoustic transducer (10) of a signal receiver, especially a television receiver, with a differential amplifier-IC (22) via which the low frequency signal at the input (pin 1) is amplified or suppressed and is supplied or inhibited at the output (pin 4) and with a frequency-dependent negative feedback with an RC-section comprising a resistor (11), between the output (pin 4) and the inverting input (pin 2), and a series circuit, between the inverting input (pin 2) and earth and comprising a resistor (12) and a capacitor (16), the receiver being provided with a detector circuit which supplies a voltage as long as a signal is received, a voltage which is derived via dropping resistors (15, 17) from the operating voltage (UB pin 14) being fed to the capacitor (16) of the negative feedback circuit (11, 12, 16) and this derived voltage being controllable by means of a semiconductor switch (18) by a voltage which corresponds to the voltage supplied by the detector (at connection 21) and is fed to the control terminal of the semiconductor switch (18), **characterised in that** a terminal of the resistor (12) of the series circuit is connected to the inverting input (pin 2), a terminal of the capacitor (16) of the series circuit is connected to earth, and the common terminal of the resistor (12) and the capacitor (16) is connected to the dropping resistor (17), that the semiconductor switch (18) is connected between the common terminal of the dropping resistors (15, 17) and earth and that the voltage fed to the semiconductor switch (18) is applied to a series circuit comprising resistors (19, 20) connected between the connection (21) and earth, the common connection of said resistors (19, 20) being connected to the control terminal of the semiconductor switch (18), so that the voltage inhibiting the IC (22) for noise suppression is switched on and off with such a delay that, upon switching on from the stand-by state, the voltage at the capacitor (16) is discharged with a time constant which suppresses the switching-on click noise, and that, upon switching into the stand-by state, the time constant of the RC-section (11, 12, 16) is so selected relative to the values of the connected jointly-determining resistors that an inhibiting voltage acts at the inverting input (pin 2) of the IC (22) before a switching-off click noise can be heard.

## Revendications

1. Amplificateur basse fréquence pour le transducteur électroacoustique (10) d'un récepteur de signaux, notamment d'un récepteur de télévision, comprenant un amplificateur différentiel à circuit intégré (22) servant à amplifier et/ou à supprimer le signal basse fréquence disponible à l'entrée (connexion 1) et à le délivrer et/ou à le bloquer à la sortie (connexion 4), et un circuit de contre-couplage subordonné à la fréquence avec un circuit RC formé par une résistance (11) disposée entre la sortie (connexion 4) et l'entrée inverseur (connexion 2) ainsi qu'un montage en série avec une résistance (12) et un condensateur (16) et disposé entre l'entrée inverseur (12) et la masse, le récepteur étant équipé d'un circuit détecteur qui délivre une tension pendant la réception d'un signal, le condensateur (16) du circuit de contre-couplage (11, 12, 16) recevant une tension dérivée

4

par des résistances amont (15, 17) à partir de la tension de service (UB, connexion 14) et cette tension dérivée pouvant être commandée au moyen d'un commutateur à semi-conducteurs (18) par une tension correspondant à la tension délivrée par le détecteur (à la connexion 21) et qui est appliquée à la connexion de commande du commutateur à semi-conducteurs (18), caractérisé en ce qu'une connexion de la résistance (12) du montage en série est reliée à l'entrée inverseur (connexion 2), une connexion du condensateur (16) du-montage en série à la masse et la connexion commune de la résistance (12) et du condensateur (16) à la résistance self (17), que le commutateur à semi-conducteurs (18) est disposé entre la connexion commune des résistances amont (15, 17) et la masse, et que la tension fournie au commutateur à semi-conducteurs (18) est appliquée à un montage en série comprenant des résistances (19, 20) disposées entre la connexion (21) et la masse, dont la connexion commune est reliée à la connexion de commande du commutateur à semi-conducteurs (18), de sorte que, pour supprimer les bruts parasites, la tension de blocage du circuit intégré (22) est connectée et déconnectée avec un retard tel, que la tension disponible au condensateur (16) au moment de la mise en marche à partir de l'état d'attente est déchargée avec une constante de temps qui supprime le claquement de mise en marche et que, pour passer à l'état d'attente, la constante de temps du circuit RC (11, 12, 16) est choisie au-dessus des valeurs des résistances connectées coassociées de manière qu'une tension de blocage devient active à l'entrée inverseur (broche 2) du circuit intégré (22) avant que le claquement d'arrêt ne devienne perceptible.